# EUROPEAN PATENT APPLICATION

(11) **EP 2 144 305 A1**
(43) Date of publication of application: **13.01.2010**
(21) Application number: 08104667.4
(22) Date of filing: 08.07.2008
(51) Int. Cl.: H01L 33/00

(54) **Semiconductor light-emitting device**

(71) Applicant: Volohovs, Dmitrijs, Riga LV 1082 (LV); Mironovs, Sergejs, Riga LV 1082 (LV)
(72) Inventor: Volohovs, Dmitrijs, Riga LV 1082 (LV); Mironovs, Sergejs, Riga LV 1082 (LV)
(74) Representative: Anohins, Vladimirs

(57) **Abstract**

The semiconductor light-emitting device (11) of the present invention has a housing (12) having a cavity (26) with a bottom; a leadframe embedded in the housing (12) having a plurality of internal contact pads (16, 18) disposed at the bottom of the cavity (26); a LED chip (20) mounted in the cavity (26) and electrically connected with the internal contact pads (16, 18), characterized in that it further comprises a layer (24) of black non-transparent material covering the bottom of the cavity (26) and the internal contact pads (16, 18) of the leadframe. Further, a method of manufacture of the semiconductor light-emitting device is described.

## Description

### FIELD OF THE INVENTION

The present invention relates to a semiconductor light-emitting device, and more particularly to SMT type LED device for use in lighting and display applications.

### BACKGROUND

Today, light emitting diodes (LEDs) are capable to emit each of red, green, and blue colors. As a result, the LED display apparatus, made up of an array of LEDs, are being used in many fields. The full-color LED display boards have been widely used for displaying pictures and information not only in sports fields and recreation grounds but also for outdoor and indoor advertisements, and in area of events and shows.

Surface mount technology (SMT) is a method for constructing electronic circuits in which the electronic components are mounted directly onto the surface of printed circuit boards (PCBs). In the industry it has largely replace the through-hole technology construction method of fitting components with wire leads into holes in the circuit board.

A typical SMT type LED device is formed by die-bonding an LED chip to the surface at the bottom of a cavity in a polymer housing or package with leads formed in the package. Wire bonding is performed as required. Next, encapsulating resin is introduced into the cavity to at least cover the LED chip.

A contrast ratio is a measure of a display system, defined as the ratio of the luminance of the brightest color (white) to that of the darkest color (black) that the system is capable of producing. A high contrast ratio is a desired aspect of any display. The full color LED displays require the highest level of contrast.

The full color LED display typically consists of a large number of LEDs. When LEDs are illuminated, external light such as sunlight or artificial lighting incident at certain angles reflects primarily off surface of the LED encapsulating resin resulting in degradation in the display contrast. Light reflection also occurs at LED housing sidewalls and a leadframe, located inside LED housing, thereby causing further display contrast degradation.

In the same manner, when LED is not illuminated, external light reflects from surface of encapsulating resin, from housing sidewalls and a leadframe. As a result, reflected light produces glare, which appears white to the observer.

There are different ways of improving contrast ratio. As an example, the LED NSSM016, manufactured by Nichia, Japan, has black coating atop of LED upper surface. The housing of NSSM016 is made from white material, and to increase black level Nichia apply this black coating at top area of the housing. But, the LED still appears to be whitish because of internal reflection of light.

Another way to increase contrast is to use LEDs known as "black LED". This type of LED has black housing and they are covered by light-scattering material. An example of such a LED device are NSSM026 and NESM005, both manufactured by Nichia, Japan. Both devices have a black housing and are covered with by pigmented encapsulating resin. But, they both still appear to be white when off, because external light reflecting from leadframe, located inside the housing.

A leadframe of LED is typically produced from tinned or silver plated copper. Tin and silver are light reflecting materials, and this property of tin and silver causes internal reflection problem.

The present invention will solve the problem of internal reflection of light from LED device using method and technology described below.

### SUMMARY OF THE INVENTION

The semiconductor light-emitting device of the present invention has a housing having a cavity with a bottom; a leadframe embedded in the housing having a plurality of internal contact pads disposed at the bottom of the cavity; a LED chip mounted in the cavity and electrically connected with the internal contact pads, **characterized in that** it further comprises a layer of black non-transparent material covering the bottom of the cavity and the internal contact pads of the leadframe.

As a result, when light from an external source shines on the device it is not reflected from the internal contact pads. Therefore the contrast level is improved and the device looks blacker.

The proposed solution may be used separately or in combination with other known method of improving contrast of LED devices.

It is preferable to manufacture the device housing from black material.

Still further it is preferable to cover the device with light scattering material to reduce glare from the surface of the light-emitting device.

The semiconductor light-emitting device method of manufacture of the present invention comprised the steps of:
providing a housing having a cavity with a bottom, a leadframe embedded in the housing having a plurality of internal contact pads disposed at the bottom of the cavity;
mounting a LED chip in the cavity;
electrically connecting the LED chip to the internal contact pads of the leadframe;
forming a layer of black non-transparent material at the bottom of the cavity covering the bottom of the cavity and the internal contact pads of the leadframe.

### BRIEF DESCRIPTION OF DRAWINGS

FIG. 1 shows a prior art LED device;
FIG. 2 shows perspective view of LED device in accordance with present invention;
FIG. 3 shows cross sectional view of LED device in accordance with present invention.

### DETAILED DESCRIPTION

The present invention will be further described by way of non-limitative examples with reference to the accompanying drawings. The forms of the following drawings are intended as example of light emitting device that represent the technology behind the present invention. Further, the size and relative position shown in each drawing may be enlarged for the purpose of descriptive clarity.

### PARTS LIST

To assist the reader in understanding the present invention, all reference numbers used herein are summarized in the table below, along with the elements they represent:
10 semiconductor light-emitting device
11 semiconductor light-emitting device
12 housing
14 contact for surface mounting
16 internal contact pad
18 internal contact pad
20 LED chip
22 bounding wire
24 black non-transparent layer
26 cavity.

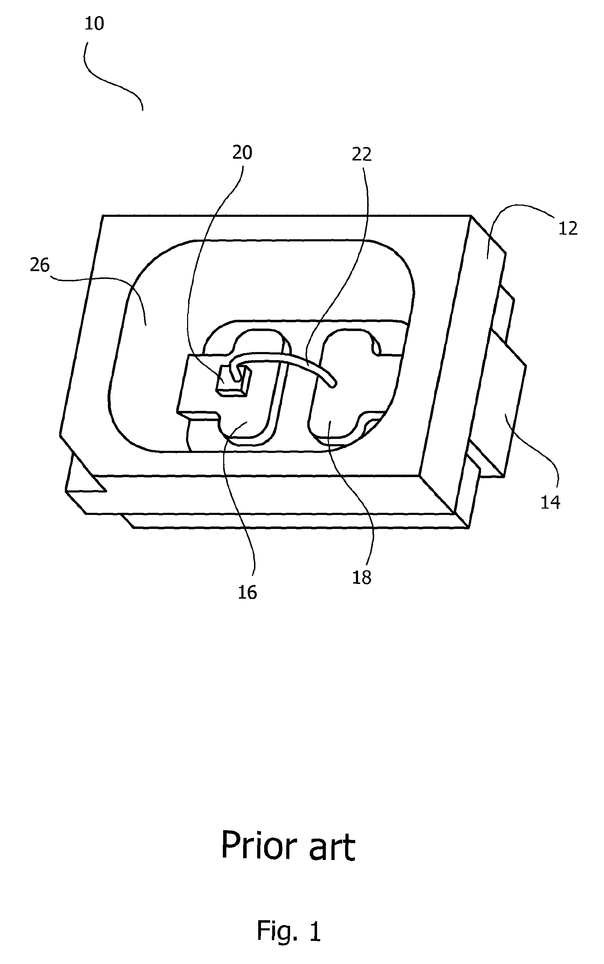

Fig.1 is showing a prior art light-emitting device 10 in SMT type package or housing. SMT type LED is a LED with leads, which can be surface mount on a substrate. Substrate can be, for example, a printed circuit board.

A SMT type LED provided with a housing 12 as shown in Fig.1 has a LED chip 20 die-bonded to the surface of first contact pad 16 at the bottom of a cavity 26 in a housing 12.

During wire bonding process as necessary with wire 22 such as gold wire, one end of wire 22 is bonded to the LED chip 20 and the other end of wire 22 is bonded to second contact pad 18 at the bottom of the cavity in the housing 12.

After wire bonding, encapsulating resin is introduced into the cavity 26 to cover at least the LED chip 20. In addition, the LED device 10 may be provided with second encapsulating layer, for example, which has light scattering material.

Contact pads 16 and 18 are clearly visible and reflect substantial amount of ambient light and thus reduce contrast level of LED device.

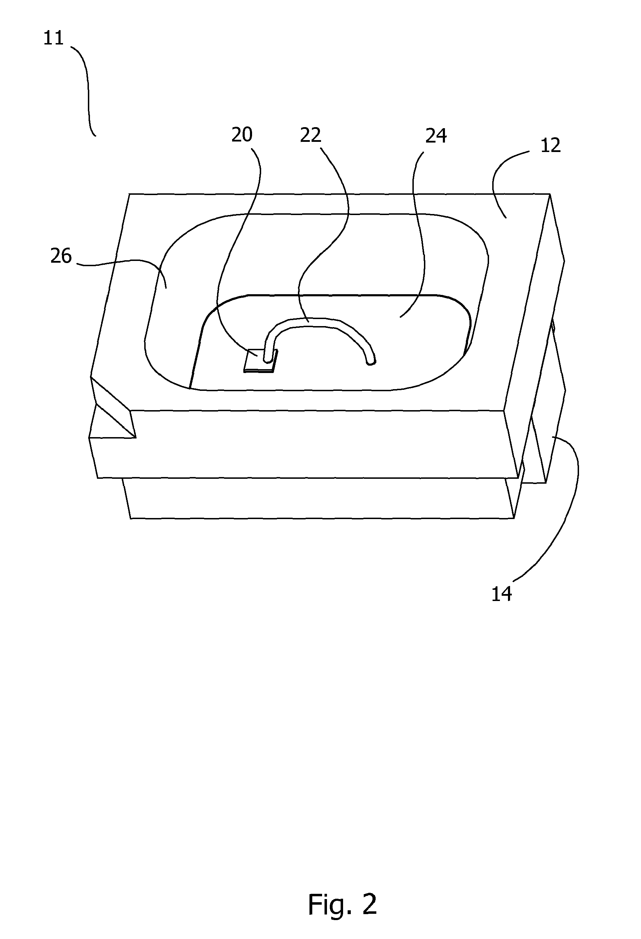

Fig.2 is showing perspective view of LED device 11 in accordance with present invention. Contact pads 16 and 18 are covered with black non-transparent layer 24, and thus, the contact pads 16 and 18 do not reflect ambient light.

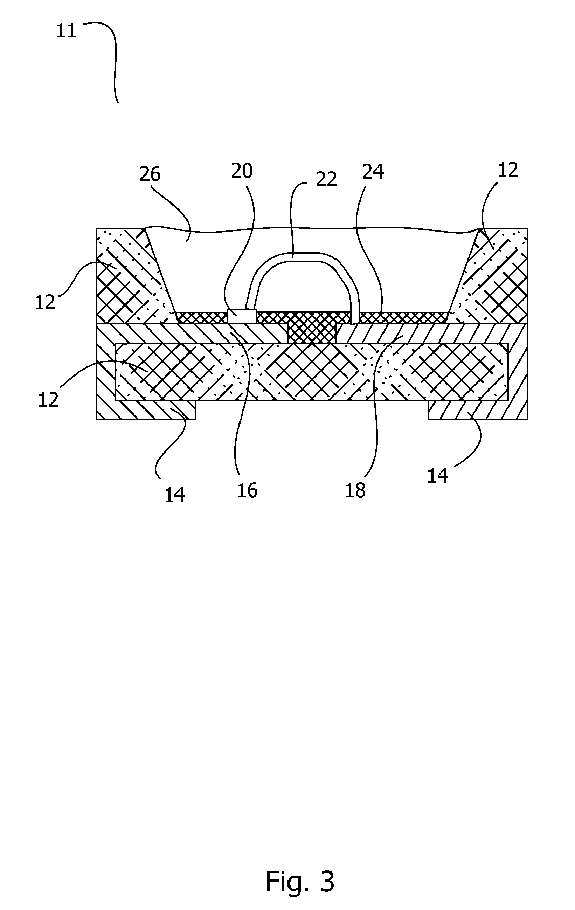

Fig.3 is showing cross sectional view of LED device 11 in accordance with the present invention.

As shown, the LED device 10 comprises a package 12, with first contact pad 16 and second contact pad 18. The first contact pad 16 and second contact pad 18 are protruding package 12 and bended to form contacts 14 which are used for surface mount of the LED device 11 onto a substrate.

Further, the LED device 11 comprises a non-reflective layer 24 of black non-transparent material, which is introduced after wire bonding process. This layer 24 is covering first contact pad 16 and second contact pad 18, and the rest of the bottom part of housing 12.

Total height of the black non-transparent layer 24 is lower than the height of the LED chip 20. Preferably, the height of first layer 24 should not exceed 1/3 of LED chip 20 height to allow emitted light to go out from sides of LED chips.

In a preferred embodiment, the LED chip 20 is of EZBright290 series, manufactured by Cree, USA. The height of EZBright290 chip is 100 micron. The height of first layer 24, preferably should be within 25-30 micron range.

To prevent reflection of ambient light from contact pads 16 and 18, it is necessary that the material of first layer 24 is black and non-transparent; it also should be electrically non-conductive. In a preferred embodiment, the material of the layer 24 is EPO-TEK 353ND BLACK, manufactured by Epoxy Technology.

Optionally, the layer 24 can also be thermally conducting to enhance heat dissipation from the LED chip and decrease the operating temperature of the LED chip.

The layer 24 can be applied by precision dispensing system, for example, by DS-500, manufactured by ASM Pacific Technology, The Netherlands. This system allows dispensing precisely controlled amount of material with very high accuracy.

Precisely controlled amount of material forming the layer 24 will be evenly distributed across bottom of package 12 and will cover first contact pad 16 and second contact pad 18, and will cover partially sides of LED chip 20. It is also clear that the layer 24 will cover entire surface of the bottom of the housing 12.

After dispensing of the layer 24, it needs to be cured in oven during period of time, recommended by material manufacturer.

After curing of the layer 24, the cavity 26 can be filled with transparent encapsulating resin by using the same precision dispensing system. The material of encapsulating resin can be EPO-TEK H20E, manufactured by Epoxy Technology, USA.

For even better improvements of contrast it is possible to produce housing 12 of LED device 10 from black colored material, for example, AMODEL Polyphthalamide (PPA), manufactured by Solvay Advanced Polymers.

Thus, using this invention, it is possible to increase the contrast level of standard LED device without changing its housing or leadframe. Therefore standard package is used, which means, that no change in assembling equipment is required. Neither change in printed circuit board or display design is required.

The invention is in no way limited to the description and embodiments described above and represented in the drawings, and may be realized in different shapes and dimensions, without departure from the scope of invention.

## Claims

1. A semiconductor light-emitting device (11) comprising:
a housing (12) having a cavity (26) with a bottom;
a leadframe embedded in the housing (12) having a plurality of internal contact pads (16, 18) disposed at the bottom of the cavity (26);
a LED chip (20) mounted in the cavity (26) and electrically connected with the internal contact pads (16, 18),
**characterized in that**
it further comprises a layer (24) of black non-transparent material covering the bottom of the cavity (26) and the internal contact pads (16, 18) of the leadframe.

2. The device of claim 1 comprising a plurality of LED chips (20) arranged next to one another in the cavity (26).

3. The device of claim 1 wherein the housing (12) is covered by black material.

4. The device of claim 1 wherein the housing (12) is made of black material.

5. The device of claim 1 wherein the cavity (26) is further filled with transparent encapsulating resin.

6. A method of manufacture of a semiconductor light-emitting device (11) comprising:
providing a housing (12) having a cavity (26) with a bottom, a leadframe embedded in the housing having a plurality of internal contact pads (16, 18) disposed at the bottom of the cavity (26);
mounting a LED chip (20) in the cavity (26);
electrically connecting the LED chip (20) to the internal contact pads (16, 18) of the leadframe;
forming a layer (24) of black non-transparent material at the bottom of the cavity 26) covering the bottom of the cavity (26) and the internal contact pads (16, 18) of the leadframe.

7. The method of claim 6 further comprising:
filling the cavity (26) with transparent encapsulating resin.
